# EUROPÄISCHE PATENTSCHRIFT

(11) **EP 3 360 171 B1**
(45) Veröffentlichungstag und Bekanntmachung des Hinweises auf die Patenterteilung: **19.02.2025**
(21) Anmeldenummer: 16766869.8
(22) Anmeldetag: 01.09.2016
(51) Int. Cl.: H10N 30/50, H10N 30/30, H10N 30/20, H10N 30/87, H10N 30/88, H03K 17/96

(54) **BAUELEMENT ZUR ERZEUGUNG EINES AKTIVEN HAPTISCHEN FEEDBACKS**
COMPONENT FOR PRODUCING ACTIVE HAPTIC FEEDBACK
COMPOSANT POUR GÉNÉRER UNE RÉTROACTION HAPTIQUE ACTIVE

(30) Priorität: 09.10.2015 DE 102015117262
(43) Veröffentlichungstag der Anmeldung: 15.08.2018
(73) Patentinhaber: TDK Electronics AG, 81671 München (DE)
(72) Erfinder: RINNER, Franz, 8530 Deutschlandsberg (AT)
(74) Vertreter: Epping - Hermann - Fischer
(86) Internationale Anmeldenummer: PCT/EP2016/070638
(87) Internationale Veröffentlichungsnummer: WO 2017/060011

(56) Entgegenhaltungen:
- EP-A1- 2 434 555
- US-A- 5 729 077
- US-A- 5 982 304
- US-A1- 2006 028 095
- US-A1- 2011 310 055
- US-A1- 2015 209 564

## Beschreibung

Bauelement zur Erzeugung eines aktiven haptischen Feedbacks Die vorliegende Erfindung betrifft ein Bauelement zur Erzeugung eines aktiven haptischen Feedbacks. Es handelt sich dabei um ein Bauelement, das dazu ausgestaltet ist, eine Rückmeldung an einen Nutzer zu erzeugen, wenn dieser eine Kraft auf das Bauelement ausübt. Ein solches Bauelement kann beispielsweise in einem Knopf, z.B. in einem Betätigungsknopf für Instrumente, eingesetzt werden. Das Bauelement kann das aktive haptische Feedback beispielsweise dazu erzeugen, um einem Nutzer mitzuteilen, dass von ihm vorgenommene Einstellungen erfolgreich von dem Bauelement umgesetzt werden.

Elemente zur Erzeugung von aktivem haptischem Feedback sind beispielsweise von Vibrationsalarmen in Mobiltelefonen bekannt. Diese weisen Motoren mit einer Unwucht auf. Sie führen jedoch zu einem ungleichmäßigen Feedback und weisen darüber hinaus eine vergleichsweise hohe Bauhöhe auf.

US 2011/310055 A1 zeigt die Verwendung eines piezoelektrischen Aktuators zur Erzeugung eines haptischen Feedbacks, wobei der Aktuator separate Elektroden zur Messung eines Drucks und zur Erzeugung einer Vibration aufweist. EP 2434555 A1 zeigt ein piezoelektrisches Bauelement mit Kupferelektroden.

US 5,729,077 A zeigt ein piezoelektrisches Vielschichtbauelement mit kegelstumpfförmigen Endkappen, das auch als Sensor konfiguriert werden kann und dazu mit einem Berlincourt d33-Messgerät verbunden ist. US 2006/028095 A1 zeigt ein Bauelement, das sowohl als Sensor als auch als Aktuator verwendet werden kann. US 2015/209564 A1 zeigt ein weiteres piezoelektrisches Wandlerelement.

Aufgabe der vorliegenden Erfindung ist es daher, ein verbessertes Bauelement zur Erzeugung eines aktiven haptischen Feedbacks anzugeben.

Diese Aufgabe wird durch ein Bauelement gemäß dem vorliegenden Anspruch 1 gelöst.

Es wird ein Bauelement zur Erzeugung eines aktiven haptischen Feedbacks vorgeschlagen, das einen Grundkörper mit in einer Stapelrichtung übereinandergestapelten ersten und zweiten Innenelektroden aufweist, wobei zwischen den Innenelektroden jeweils eine piezoelektrische Schicht angeordnet ist, wobei das Bauelement dazu ausgestaltet ist, eine auf das Bauelement ausgeübte Kraft zu erkennen und ein aktives haptisches Feedback zu erzeugen, wenn eine auf das Bauelement ausgeübte Kraft erkannt wird, wobei das haptische Feedback dadurch erzeugt wird, dass zwischen den ersten und zweiten Innenelektroden eine elektrische Spannung angelegt wird, die zu einer Längenänderung des Grundkörpers führt.

Das Feedback wird als aktives Feedback bezeichnet, da es von dem Bauelement selbst erzeugt wird. Das Feedback wird als haptisches Feedback bezeichnet, da ein Nutzer es über seinen Tastsinn wahrnehmen kann.

Bei der Längenänderung des Grundkörpers kann es sich insbesondere um eine Längenänderung in eine Richtung senkrecht zur Stapelrichtung handeln. Eine solche Längenänderung wird auch als Querkontraktion bezeichnet. Zu der Längenänderung in die Richtung senkrecht zur Stapelrichtung kann es in Folge des piezoelektrischen Effekts kommen, der in den piezoelektrischen Schichten durch die zwischen den ersten und zweiten Innenelektroden angelegte Spannung entsteht.

Das Bauelement kann ferner dazu ausgestaltet sein die Längenänderung des Grundkörpers in eine Richtung senkrecht zur Stapelrichtung in eine Längenänderung des Bauelements in Stapelrichtung umzuwandeln. Insbesondere die Längenänderung des Bauelements in Stapelrichtung kann als aktives haptisches Feedback von einem Nutzer wahrgenommen werden.

Dadurch, dass das aktive haptische Feedback mittels einer zwischen den ersten und den zweiten Innenelektroden angelegten Spannung erzeugt wird, bietet das Bauelement viele Freiheitsgrade in der Ausgestaltung des aktiven haptischen Feedbacks. Dieses kann variiert werden, indem die Dauer des Anlegens einer Spannung verändert wird oder indem die Höhe einer angelegten Spannung verändert wird oder indem Intervalle, in denen keine Spannung anliegt, mit Intervallen, in denen Spannung anliegt, abwechseln. Auf diese Weise können verschiedene Arten von Feedback für verschiedene Ereignisse definiert werden.

Die ersten und die zweiten Innenelektroden können sich dahingehend unterscheiden, dass sie mit unterschiedlichen Außenelektroden des Bauelementes kontaktiert sind und dass dementsprechend zwischen ihnen eine Spannung angelegt werden kann.

Bei der piezoelektrischen Schicht kann es sich um eine Blei-Zirkonat-Titanat-Keramik (PZT-Keramik) handeln. Die piezoelektrischen Schichten können so polarisiert sein, dass durch das Anlegen einer Wechselspannung zwischen den ersten und den zweiten Innenelektroden und dem damit verbundenen piezoelektrischen Effekt, die Längenänderung des Grundkörpers hervorgerufen wird. Die PZT-Keramik kann ferner zusätzlich Nd und Ni enthalten. Alternativ kann die PZT-Keramik ferner zusätzlich Nd, K und gegebenenfalls Cu aufweisen. Alternativ können die piezoelektrischen Schichten eine Pb(ZrₓTi₁₋ₓ)O₃ + y Pb(Mn_{1/3}Nb_{2/3})O₃ enthaltenden Zusammensetzung aufweisen.

Bei dem Grundkörper kann es sich um ein gesintertes Teil handeln, das die Innenelektroden und die piezoelektrischen Schichten aufweist.

Auf einer Oberseite und/oder einer Unterseite des Bauelements ist ein kegelstumpfförmiges Blech angeordnet. Das Blech kann dazu ausgestaltet sein, eine Längenänderung des Grundkörpers in eine Richtung senkrecht zur Stapelrichtung in eine Längenänderung des Bauelements in Stapelrichtung zu transformieren. Das Blech kann dazu dienen, eine Längenänderung des Grundkörpers in Stapelrichtung, zu der es infolge einer Querkontraktion des Grundkörpers kommt, zu verstärken. Zu diesem Zweck kann das Blech derartig geformt sein, dass es beim Zusammenziehen oder Auseinanderziehen der Randbereiche des Blechs zu einer erheblichen Anhebung oder Absenkung eines mittleren Bereiches des Blechs kommt. Das Blech kann mit dazu beitragen, die Querkontraktion des Grundkörpers in eine erhebliche Längenänderung in Stapelrichtung des Bauelementes umzuwandeln.

Das kegelstumpfförmige Blech kann einen Randbereich aufweisen, der auf der Oberseite beziehungsweise der Unterseite des Bauelements befestigt ist. Der Randbereich kann beispielsweise mittels Kleben, Löten oder Schweißen an dem Grundkörper des Bauelementes befestigt sein. Das Blech kann ferner einen mittleren Bereich aufweisen, der in Stapelrichtung von der Oberseite beziehungsweise der Unterseite des Grundkörpers absteht. Der Abstand des mittleren Bereichs des Blechs von der Oberseite beziehungsweise der Unterseite kann sich erheblich verändern, wenn der Grundkörper infolge einer zwischen den Innenelektroden angelegten Spannung eine Querkontraktion erfährt.

Das Blech weist Titan auf oder kann aus Titan bestehen.

Titan weist insbesondere für die hier vorliegende Anwendung des Bauelementes zur Erzeugung eines aktiven haptischen

Feedbacks wesentliche Vorteile auf. Das Bauelement kann beispielsweise als Knopf verwendet werden, wobei ein aktives haptisches Feedback erzeugt werden soll, wenn ein Nutzer auf den Knopf drückt. Wird ein solcher Knopf von einem Menschen betätigt, so ist es nahezu unvermeidlich, dass Feuchtigkeit, beispielsweise in Form von Fingerschweiß, auf dem Knopf zurückbleibt. Diese kann zu Korrosion führen. Titan ist jedoch ein besonders korrosionsbeständiges Material, sodass es das Bauelement gut vor Langzeitschäden durch Korrosion schützen kann.

Ferner weist Titan eine hohe mechanische Belastbarkeit auf, sodass es die Lebensdauer des Bauelementes verlängern kann.

Außerdem weist Titan einen thermischen Ausdehnungskoeffizienten auf, der sehr nahe an dem thermischen Ausdehnungskoeffizienten des Grundkörpers liegt. Dadurch wird die Verbindungsstelle des Blechs mit dem Grundkörper bei einer Veränderung der Temperatur nicht wesentlich mechanisch belastet. Beispielsweise können sowohl das Blech als auch der Grundkörper einen thermischen Ausdehnungskoeffizienten zwischen 8 und 9 ppm/K aufweisen. Ferner weist das Bauelement eine Messeinheit zur Messung einer zwischen den ersten und den zweiten Innenelektroden erzeugten Spannung auf, die infolge der auf den Grundkörper ausgeübten Kraft entsteht, wobei das Bauelement dazu ausgestaltet ist, anhand der von der Messeinheit erfassten Werte die auf das Bauelement ausgeübte Kraft zu erkennen.

Die Messeinheit ist ferner dazu ausgestaltet, zu erkennen, wie groß die auf das Bauelement ausgeübte Kraft ist. Dazu sind in der Messeinheit mehrere Schwellenwerte für die zwischen den ersten und den zweiten Innenelektroden erzeugte Spannung definiert, und die Messeinheit ist dazu ausgestaltet, jeweils zu prüfen, welche dieser Schwellenwerte überschritten sind.

Die ersten und zweiten Innenelektroden können dementsprechend eine Doppelfunktion in dem Bauelement wahrnehmen. Sie können einerseits dazu dienen, eine auf das Bauelement ausgeübte Kraft zu erkennen, da in diesem Fall zwischen ihnen eine Spannung erzeugt wird, und andererseits die Längenänderung des Bauelementes auslösen, mittels der das aktive haptische Feedback erzeugt wird, wenn zwischen ihnen eine Wechselspannung angelegt wird.

Alternativ oder ergänzend kann das Bauelement eine dritte Innenelektrode aufweisen, die mit einem Messkontakt verbunden ist. Die dritte Innenelektrode ist nicht mit einer ersten Außenelektrode, mit der die ersten Innenelektroden verbunden sind, und nicht mit einer zweiten Außenelektrode, mit der die zweiten Innenelektroden verbunden sind, elektrisch kontaktiert.

Das Bauelement kann dazu ausgestaltet sein, eine zwischen der dritten Innenelektrode und einer der ersten Innenelektroden erzeugte Spannung zu messen, die infolge einer auf den Grundkörper ausgeübten Kraft entsteht, wobei das Bauelement dazu ausgestaltet ist, anhand der von der gemessenen Spannung die auf das Bauelement ausgeübte Kraft zu erkennen. Die eine ersten Innenelektroden kann unmittelbar zu der dritten Innenelektrode benachbart sein.

Die Verwendung einer separaten dritten Innenelektrode, die nicht zur Erzeugung einer Längenänderung des Grundkörpers genutzt wird, sondern lediglich dem Erkennen der auf das Bauelement ausgeübten Spannung dient, kann vorteilhaft sein, um eine höhere Sensitivität zu erreichen. Beispielsweise kann der Abstand zwischen der dritten Innenelektrode und der zu ihr benachbarten ersten Innenelektrode größer als die Abstände zwischen den zueinander benachbarten ersten und den zweiten Innenelektroden. Dementsprechend liegt zwischen der dritten Elektrode und der benachbarten ersten Innenelektrode bei gleicher mechanischer Kraft eine höhere Spannung an, sodass eine Schwelle zum Detektieren einer Kraft sich verringert.

Die dritte Innenelektrode kann in Stapelrichtung mittig in einem Stapel von ersten und zweiten Innenelektroden angeordnet sein. Ein solcher Aufbau ist symmetrisch. Dadurch kann es durch die dritte Innenelektrode nicht zu Störungen des Bauelementes kommen und das Bauelement wird in seiner Funktionsweise nicht beeinträchtigt.

Alternativ kann die dritte Innenelektrode derart in dem Grundkörper angeordnet sein, dass alle ersten und zweiten Innenelektroden auf einer Seite der dritten Innenelektrode angeordnet sind. Durch diesen Aufbau wird sichergestellt, dass die dritte Innenelektrode lediglich zu einer weiteren Innenelektrode benachbart ist. Dementsprechend wird der Bereich des Bauelementes verringert, der nicht zur Erzeugung der Querkontraktion aktiv genutzt werden kann.

Der Grundkörper kann ein Loch aufweisen, das sich in Stapelrichtung von einer Unterseite des Grundkörpers zu einer Oberseite des Grundkörpers erstreckt und einen mittleren Bereich des Grundkörpers ausschneidet. Auf diese Weise kann die Kapazität zwischen den ersten und den zweiten Innenelektroden verringert werden, sodass es ermöglicht wird, das Bauelement mit einer geringeren Leistung zu betreiben.

Der Grundkörper kann eine senkrecht zur Stapelrichtung angeordnete Grundfläche aufweisen, die rund ist. Gegenüber einer quadratischen Grundfläche sind hierbei sozusagen die Eckbereiche abgeschnitten worden. Auch dieses kann dazu dienen, die Kapazität des Grundkörpers zu verringern. Wird die Kapazität des Grundkörpers verringert, so ist eine geringere Leistung erforderlich, um das Bauelement zu betreiben

Der Grundkörper kann eine senkrecht zur Stapelrichtung angeordnete Grundfläche aufweisen, deren Seitenlänge zwischen 10 und 30 mm liegen, wobei der Grundkörper in der Stapelrichtung eine Höhe zwischen 0,5 und 2,0 mm aufweisen kann.

Die Innenelektroden können Kupfer aufweisen oder aus Kupfer bestehen.

Gemäß einem weiteren Aspekt betrifft die vorliegende Erfindung eine Anordnung, die mehrere übereinandergestapelte Bauelemente wie oben beschrieben aufweist. Die Bauelemente sind dabei in Stapelrichtung übereinandergestapelt. Die Längenänderungen der Bauelemente in Stapelrichtung addieren sich dabei zueinander, sodass insgesamt mit der Anordnung ein stärkeres Feedback erzeugt werden kann, da die Längenänderung der Anordnung um ein Vielfaches größer ist als die Längenänderung eines einzelnen Bauelementes. Die mittleren Bereiche der jeweils auf einer Oberseite und einer Unterseite der Bauelemente angeordneten Bleche sind dabei fest miteinander verbunden.

Im Folgenden wird die vorliegende Erfindung anhand der Figuren genauer beschrieben.
- Figur 1: zeigt einen Querschnitt durch ein Bauelement zur Erzeugung eines aktiven haptischen Feedbacks gemäß einem ersten Ausführungsbeispiel,
- Figur 2: zeigt eine perspektivische Ansicht eines Bauelementes,
- Figur 3: zeigt einen Querschnitt durch den Grundkörper des Bauelementes,
- Figur 4: zeigt einen Querschnitt durch den Grundkörper eines Bauelementes gemäß einem zweiten Ausführungsbeispiel,
- Figur 5: zeigt einen Querschnitt durch einen Grundkörper eines Bauelementes gemäß einem dritten Ausführungsbeispiel,
- Figur 6: zeigt eine piezoelektrische Schicht, die mit einer ersten Innenelektrode bedruckt ist,
- Figur 7: zeigt eine piezoelektrische Schicht, die mit einer zweiten Innenelektrode bedruckt ist,
- Figur 8: zeigt eine piezoelektrische Schicht, die mit einer dritten Innenelektrode bedruckt ist,
- Figur 9: zeigt den Grundkörper eines Bauelements gemäß einem vierten Ausführungsbeispiels.

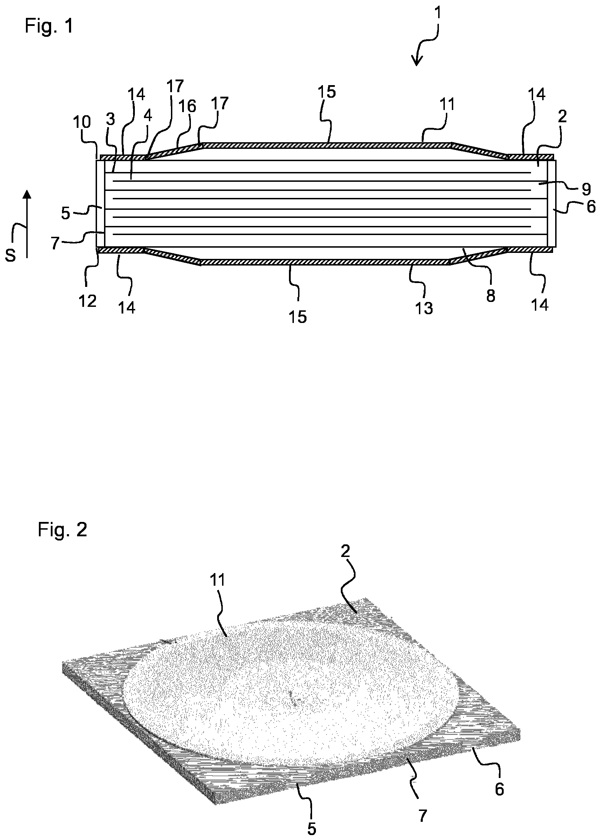

Figur 1 zeigt einen Querschnitt durch ein Bauelement 1 zur Erzeugung eines aktiven haptischen Feedbacks. Figur 2 zeigt das Bauelement 1 in einer alternativen Ausführungsform in einer perspektivischen Ansicht.

Das Bauelement 1 weist einen Grundkörper 2 mit in einer Stapelrichtung S übereinandergestapelten ersten Innenelektroden 3 und zweiten Innenelektroden 4 auf. Die ersten Innenelektroden 3 sind mit einer ersten Außenelektrode 5 kontaktiert. Die zweiten Innenelektroden 4 sind mit einer zweiten Außenelektrode 6 kontaktiert. Die erste und die zweite Außenelektrode 5, 6 sind jeweils auf einer Seitenfläche 7 des Grundkörpers 2 angeordnet, deren Flächennormale sich senkrecht zur Stapelrichtung S erstreckt. Bei dem in Figur 1 gezeigten Bauelement 1 sind die erste und die zweite Außenelektrode 5, 6 auf gegenüberliegenden Seitenflächen 5 angeordnet. Bei dem in Figur 2 gezeigten Bauelement 1 sind die erste und die zweite Außenelektrode 5, 6 auf der gleichen Seitenfläche 7 angeordnet.

Der Grundkörper 2 weist in Stapelrichtung S eine geringe Höhe auf. Ferner weist der Grundkörper 2 eine Grundfläche 8 auf, deren Flächennormale parallel zur Stapelrichtung S ist. Die Ausdehnung der Grundfläche 8 ist wesentlich größer als die Höhe des Grundkörpers 2. Damit ergibt sich ein flacher und breiter Grundkörper 2. Beispielsweise kann die maximale Ausdehnung des Grundkörpers 2 in eine Richtung senkrecht zur Stapelrichtung S mindestens zehnmal so groß sein wie die Höhe des Grundkörpers 2 in Stapelrichtung S. Vorzugsweise ist die Ausdehnung des Grundkörpers 2 in eine Richtung senkrecht zur Stapelrichtung S mindestens zwanzigmal so groß sein wie die Höhe des Grundkörpers 2 in Stapelrichtung S.

Ferner weist der Grundkörper 2 piezoelektrische Schichten 9 auf, die aus einem piezoelektrischen Material bestehen, z.B. aus einer PZT-Keramik. Die piezoelektrischen Schichten 9 sind zwischen den ersten und den zweiten Innenelektroden 3, 4 angeordnet. Die piezoelektrischen Schichten 9 sind derart polarisiert, dass das Anlegen einer elektrische Spannung zwischen den ersten und den zweiten Innenelektroden 3, 4 zu einer Querkontraktion des Grundkörpers 2 führt, bei der sich die Länge des Grundkörpers 2 senkrecht zur Stapelrichtung S verändert.

Die Querkontraktion führt zwangsläufig auch zu einer Längenänderung des Grundkörpers 2 in Stapelrichtung S. Diese Längenänderung in Stapelrichtung S kann als aktives haptisches Feedback von einem Nutzer des Bauelements 1 wahrgenommen werden.

Um den Effekt der Längenänderung in Stapelrichtung S weiter zu verstärken, ist auf einer Oberseite 10 des Bauelementes 1 ein oberes kegelstumpfförmiges Blech 11 angeordnet. Ferner ist auf der Unterseite 12 des Bauelements 1 ein unteres kegelstumpfförmiges Blech 13 angeordnet. Die Oberseite 10 und die Unterseite 11 liegen einander in Stapelrichtung S gegenüber. Die Flächennormalen der Oberseite 10 und der Unterseite 11 sind parallel zur Stapelrichtung S.

Die Bleche 11, 13 weisen jeweils einen Randbereich 14 auf, der fest mit dem Grundkörper 2 verbunden ist. Ferner weisen die Bleche 11, 13 jeweils einen mittleren Bereich 15 auf. Der mittlere Bereich 15 des oberen Blechs 11 steht von der Oberseite 10 des Grundkörpers 2 ab und berührt diese dementsprechend nicht. Der mittlere Bereich 15 des unteren Blechs 13 steht von der Unterseite 12 des Grundkörpers 2 ab und berührt diese dementsprechend ebenfalls nicht. Der Abstand zwischen dem mittleren Bereich 15 des oberen Blechs 11 und der Oberseite 10 beträgt 0,5 mm in einem Zustand, in dem keine Kraft auf das Bauelement 1 ausgeübt wird und keine Spannung zwischen den ersten und zweiten Innenelektroden 3, 4 anliegt. Auch der Abstand des mittleren Bereichs 15 des unteren Blechs 13 von der Unterseite 12 beträgt in diesem Zustand 0,5 mm.

Der mittlere Bereich 15 des oberen Blechs 11 ist mit dem Randbereich 14 des oberen Blechs 11 über einen Verbindungsbereich 16 verbunden. Der Verbindungsbereich 16 weist zwei Biegepunkte 17 auf, in denen sich das obere Blech besonders stark verformt, wenn der Randbereich 14 zusammengezogen oder auseinander gezogen wird. Das untere Blech 13 ist in gleicher Weise aufgebaut.

Wird nunmehr eine Spannung zwischen den ersten und den zweiten Innenelektroden 3, 4 angelegt, die zu einer Querkontraktion des Grundkörpers 2 führt, so werden die Randbereiche 14 der Bleche 11, 13 jeweils radial zusammengezogen, da diese fest mit dem Grundkörper 2 verbunden sind. Infolgedessen werden die mittlere Bereiche 15 der kegelstumpfförmigen Bleche 11, 13 in Stapelrichtung angehoben, wobei die Bleche 11, 13 insbesondere an den beiden Biegepunkten 17 verbogen werden. Der mittlere Bereich 15 des oberen Blechs 11 wird dabei in Stapelrichtung entgegengesetzt zu dem mittleren Bereich 15 des unteren Blechs 13 bewegt. Dadurch wird die Längenänderung des Bauelements 1 in Stapelrichtung S vergrößert, da sich die mittleren Bereiche 15 voneinander weg bewegen.

Wird nun die zwischen den ersten und den zweiten Innenelektroden 3, 4 anliegende Spannung umgepolt, so werden die Randbereiche der Bleche 11, 13 jeweils radial voneinander wegbewegt. Dadurch werden die beiden mittleren Bereiche 15 der Bleche 11, 13 aufeinander zu bewegt.

Auf diese Weise kann die Querkontraktion des Grundkörpers 2 in eine Längenänderung des Grundkörpers 2 in Stapelrichtung transformiert werden. Beispielsweise kann ein Bauelement 1 mit einer Höhe von weniger als 2,5 mm auf diese Weise eine Auslenkung von etwa 100 µm in Stapelrichtung S erfahren. Es wäre nicht möglich, eine Längenänderung in Stapelrichtung S von dieser Größe mit einem Bauelement 1 von dieser Höhe allein aufgrund eines direkt in Stapelrichtung S wirkenden piezoelektrischen Effektes zu erreichen.

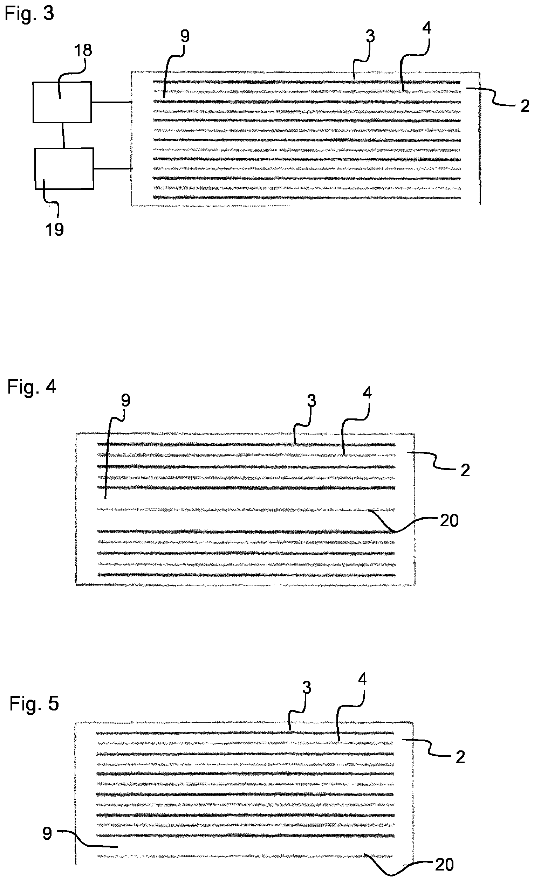

Figur 3 zeigt einen vereinfachten Querschnitt durch den Grundkörper 2 des Bauelements 1 gemäß dem ersten Ausführungsbeispiel. In Figur 3 sind die in dem Grundkörper 2 angeordneten ersten und die zweiten Innenelektroden 3, 4 eingezeichnet. Diese sind in Stapelrichtung S abwechselnd übereinandergestapelt.

Das Bauelement 1 ist dazu ausgestaltet, eine auf das Bauelement 1 einwirkende Kraft zu erkennen. Das Bauelement 1 kann beispielsweise als Knopf ausgeführt sein, der von einem Nutzer gedrückt werden kann. Dabei wird von dem Nutzer eine Kraft auf die Oberseite 10 des Bauelements 1 ausgeübt. Dadurch wird das Bauelement 1 verformt. Insbesondere wird das Bauelement 1 dadurch in Stapelrichtung S zusammengedrückt. In Folge dessen entsteht in den piezoelektrischen Schichten 9 eine elektrische Spannung. Diese elektrische Spannung liegt nunmehr zwischen den ersten und den zweiten Innenelektroden 3, 4 an.

Das Bauelement 1 ist ferner mit einer Messeinheit 18 und einer Steuereinheit 19 verschaltet. Diese sind in Figur 3 schematisch angedeutet. Die Messeinheit 18 misst die zwischen den ersten und den zweiten Innenelektroden 3, 4 anliegende Spannung. Die Steuereinheit 19 ist dazu ausgestaltet, eine Wechselspannung zwischen den ersten und den zweiten Innenelektroden 3, 4 anzulegen.

Wird keine Kraft auf das Bauelement 1 ausgeübt, so liegt keine Spannung zwischen den ersten und den zweiten Innenelektroden 3, 4 an. Drückt jedoch ein Nutzer auf das Bauelement 1, so entsteht eine elektrische Spannung, die nunmehr zwischen den ersten und den zweiten Innenelektroden 3, 4 anliegt. Die Spannung zwischen den ersten und den zweiten Innenelektroden 3, 4 wird von der Messeinheit 18 ständig vermessen. Erkennt die Messeinheit 18 nun einen Anstieg der Spannung, kann auf einen Betätigung des Knopfes geschlossen werden.

Übersteigt die Spannung zwischen den ersten und den zweiten Innenelektroden 3, 4 einen vordefinierten Schwellwert, so kann die Steuereinheit 19 das Erzeugen eines aktiven haptischen Feedbacks veranlassen. Zu diesem Zweck wird von der Steuereinheit 19 eine Wechselspannung zwischen den ersten und den zweiten Innenelektroden 3, 4 angelegt werden. Die Wechselspannung führt auf Grund des piezoelektrischen Effekts zu einer Querkontraktion des Bauelements 1 und einer damit verbundenen Längenänderung in Stapelrichtung S, die als Feedback wahrgenommen wird.

Die Messeinheit 18 ist ferner dazu ausgestaltet, zu erkennen, wie groß die auf das Bauelement 1 ausgeübte Kraft ist. Dazu sind in der Messeinheit 18 mehrere Schwellenwerte für die zwischen den ersten und den zweiten Innenelektroden 3, 4 erzeugte Spannung definiert und es wird jeweils geprüft, welche dieser Schwellenwerte überschritten sind. Die Steuereinheit 19 kann ferner dazu ausgestaltet sein, die Erzeugung eines Feedbacks zu veranlassen, dessen genaue Ausgestaltung von der Höhe der ausgeübten Kraft abhängt. Dabei können Höhe und Dauer der angelegten Wechselspannung variiert werden.

Figur 4 zeigt einen Querschnitt durch einen Grundkörper 2 eines Bauelementes 1 gemäß einem zweiten Ausführungsbeispiel. Das Bauelement 1 weist eine dritte Innenelektrode 20 auf. Die dritte Innenelektrode 20 ist weder mit der ersten Außenelektrode 5 noch mit der zweiten Außenelektrode 6 verbunden. Stattdessen ist die dritte Innenelektrode 20 mit einem zusätzlichen Messkontakt (nicht gezeigt) verbunden, der ebenfalls auf der Seitenfläche 7 des Grundkörpers 2 angeordnet ist. Die dritte Innenelektrode 20 dient dazu, eine auf den Grundkörper 2 ausgeübte Kraft zu erkennen. Zu diesem Zweck wird die zwischen der dritten Innenelektrode 20 und den beiden zu dieser benachbarten ersten Innenelektroden 3 anliegende Spannung von der Messeinheit 18 überwacht. Wird eine Kraft auf den Grundkörper 2 ausgeübt, so entsteht zwischen diesen Innenelektroden 3, 20 eine Spannung.

Die dritte Innenelektrode 20 ist mittig in einem Stapel von ersten und zweiten Innenelektroden 3, 4 angeordnet. Das Bauelement 1 weist einen symmetrischen Aufbau auf. Der Abstand zwischen der dritten Innenelektrode 20 und den zu ihr benachbarten ersten Innenelektrode 3 ist größer als die Abstände zwischen den zueinander benachbarten ersten und den zweiten Innenelektroden 3, 4. Auf Grund des größeren Abstands entsteht zwischen der dritten Innenelektrode 20 und den zu ihr benachbarten ersten Innenelektroden 3 eine höhere Spannung als zwischen einer ersten und einer dazu benachbarten zweiten Innenelektrode 3, 4, wenn eine Kraft auf das Bauelement 1 ausgeübt wird. Dadurch kann die Messsensitivität erhöht werden, da bereits geringe Kräfte ausreichen können um Spannungen zu erzeugen, die von der Messeinheit 18 erkannt werden können.

Figur 5 zeigt den Grundkörper 2 eines Bauelementes 1 gemäß einem dritten Ausführungsbeispiel. Das dritte Ausführungsbeispiel unterscheidet sich von dem zweiten Ausführungsbeispiel in der Anordnung der dritten Innenelektrode 20. Die dritte Innenelektrode 20 ist hier die Innenelektrode, die am nächsten zur Unterseite 12 des Grundkörpers 2 angeordnet ist. Der Stapel weist lediglich eine piezoelektrische Schicht 9 mit einer erhöhten Dicke auf, sodass insgesamt die Höhe des Stapels verringert werden kann beziehungsweise dass bei gleicher Stapelhöhe mehr Innenelektroden in dem Bauelement 1 angeordnet werden können.

Allerdings ist das Bauelement 1 nunmehr nicht symmetrisch aufgebaut. Wird eine elektrische Spannung zwischen den ersten und den zweiten Innenelektroden 3, 4 angelegt, kann es infolge des piezoelektrischen Effektes zu einem Verbiegen des Bauelementes 1 kommen.

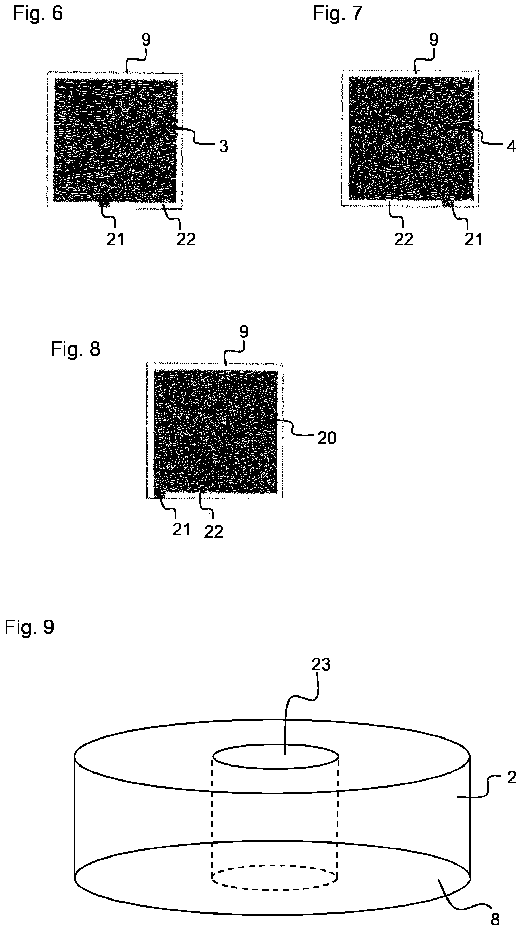

Die Figuren 6 bis 8 zeigen jeweils ein Bedruckungsbild einer piezoelektrischen Schicht 9. Figur 6 zeigt eine piezoelektrische Schicht 9, auf der eine erste Innenelektrode 3 aufgedruckt ist. Figur 7 zeigt eine piezoelektrische Schicht 9, auf der eine zweite Innenelektrode 4 aufgedruckt ist. Figur 8 zeigt eine piezoelektrische Schicht 9, auf der eine dritte Innenelektrode 20 angeordnet ist.

Jede Innenelektrode weist einen Kontaktsteg 21 auf, über den die Innenelektrode mit einer der Außenelektroden 5, 6 oder mit dem Messkontakt elektrisch kontaktiert werden. Die erste Innenelektrode 3, die zweite Innenelektrode 4 und die dritte Innenelektrode 20 unterscheiden sich in der Anordnung der jeweiligen Kontaktstege 21.

Abgesehen von dem jeweiligen Kontaktsteg 21 sind die Innenelektroden 3, 4, 20 von den Seitenflächen des Grundkörpers 2 zurückgesetzt. Dementsprechend sind hier Isolationszonen 22 angeordnet. Die Isolationszonen 22 erfahren beim Anlegen einer Wechselspannung zwischen den ersten und den zweiten Innenelektroden 3, 4 keine Querkontraktion. Dadurch kann es zu mechanischen Spannungen im Bauelement 1 kommen, die auch als Klemmeffekt bezeichnet werden. Durch diese mechanischen Spannungen kann die Längenänderung des Bauelementes 1 in Stapelrichtung S verringert werden und es kann zu einer Beschädigung des Bauelementes 1 kommen. Daher weisen die Isolationszonen 22 eine geringe Breite auf, um diesen Effekt zu minimieren.

Figur 9 zeigt einen Grundkörper 2 von einem Bauelement 1 gemäß einem vierten Ausführungsbeispiel in einer perspektivischen Ansicht. Der Grundkörper 2 weist ein Loch 23 auf, das sich in Stapelrichtung von der Unterseite 12 des Grundkörpers 2 zu der Oberseite 10 des Grundkörpers erstreckt. Das Loch 23 schneidet somit einen mittleren Bereich des Grundkörpers 2 aus. Auf diese Weise werden die Flächen und damit die Kapazität zwischen den ersten und den zweiten Innenelektroden 3, 4 verringert.

Der Grundkörper 2 weist ferner eine senkrecht zur Stapelrichtung S angeordnete runde Grundfläche 8 auf.

### Bezugszeichenliste

- 1: Bauelement
- 2: Grundkörper
- 3: erste Innenelektrode
- 4: zweite Innenelektrode
- 5: erste Außenelektrode
- 6: zweite Außenelektrode
- 7: Seitenfläche
- 8: Grundfläche
- 9: piezoelektrische Schicht
- 10: Oberseite
- 11: oberes kegelstumpfförmiges Blech
- 12: Unterseite
- 13: unteres kegelstumpfförmiges Blech
- 14: Randbereich
- 15: mittlerer Bereich
- 16: Verbindungsbereich
- 17: Biegepunkt
- 18: Messeinheit
- 19: Steuereinheit
- 20: dritte Innenelektrode
- 21: Kontaktsteg
- 22: Isolationszone
- 23: Loch
- S: Stapelrichtung

## Patentansprüche

1. Bauelement (1) zur Erzeugung eines aktiven haptischen Feedbacks,
aufweisend
einen Grundkörper (2) mit in einer Stapelrichtung (S) übereinander gestapelten ersten und zweiten Innenelektroden (3, 4), wobei zwischen den Innenelektroden (3, 4) jeweils eine piezoelektrische Schicht (9) angeordnet ist,
wobei das Bauelement (1) dazu ausgestaltet ist, eine auf das Bauelement (1) ausgeübte Kraft zu erkennen,
wobei das Bauelement (1) dazu ausgestaltet ist, ein aktives haptisches Feedback zu erzeugen, wenn eine auf das Bauelement (1) ausgeübte Kraft erkannt wird, und wobei das haptische Feedback dadurch erzeugt wird, dass zwischen den ersten und zweiten Innenelektroden (3, 4) eine elektrische Spannung angelegt wird, die zu einer Längenänderung des Grundkörpers (2) führt,
wobei auf einer Oberseite (10) und/oder einer Unterseite (12) des Bauelements (1) ein kegelstumpfförmiges Blech (11, 13) angeordnet ist,
wobei das Bauelement (1) eine Messeinheit zur Messung einer zwischen den ersten und den zweiten Innenelektroden (3, 4) erzeugten Spannung aufweist, die in Folge der auf das Bauelement (1) ausgeübten Kraft entsteht, und
wobei die Messeinheit dazu ausgestaltet ist, zu erkennen, wie groß die auf das Bauelement (1) ausgeübte Kraft ist, wozu in der Messeinheit mehrere Schwellenwerte für die zwischen den ersten und den zweiten Innenelektroden (3, 4) erzeugte Spannung definiert sind, und wobei die Messeinheit dazu ausgestaltet ist, jeweils zu prüfen, welche dieser Schwellenwerte überschritten sind.

2. Bauelement (1) gemäß Anspruch 1,
wobei das kegelstumpfförmige Blech (11, 13) einen Randbereich aufweist, der auf der Oberseite (10) bzw. der Unterseite (12) des Bauelements (1) befestigt ist, und wobei das kegelstumpfförmige Blech (11, 13) einen mittleren Bereich (15) aufweist, der in Stapelrichtung (S) von der Oberseite (10) bzw. der Unterseite (12) absteht.

3. Bauelement (1) gemäß einem der vorherigen Ansprüche, wobei das Blech (11, 13) Titan aufweist.

4. Bauelement (1) gemäß einem der vorherigen Ansprüche, ferner aufweisend eine dritte Innenelektrode (20), die mit einem Messkontakt verbunden ist.

5. Bauelement (1) gemäß Anspruch 4,
wobei das Bauelement (1) dazu ausgestaltet ist, eine zwischen der dritten Innenelektrode (20) und einer der ersten Innenelektroden (3) erzeugte Spannung zu messen, die in Folge einer auf das Bauelement (1) ausgeübten Kraft entsteht, und
wobei das Bauelement (1) dazu ausgestaltet ist, anhand der gemessenen Spannung die auf das Bauelement (1) ausgeübte Kraft zu erkennen.

6. Bauelement (1) gemäß einem der Ansprüche 4 oder 5,
wobei die dritte Innenelektrode (20) in der Stapelrichtung (S) mittig in einem Stapel von ersten und zweiten Innenelektroden (3, 4) angeordnet ist.

7. Bauelement (1) gemäß einem der Ansprüche 4 oder 5, wobei die dritte Innenelektrode (20) derart in dem Grundkörper (2) angeordnet ist, dass alle ersten und zweiten Innenelektroden (3, 4) auf einer Seite der dritten Innenelektrode (20) angeordnet sind.

8. Bauelement (1) gemäß einem der vorherigen Ansprüche, wobei der Grundkörper (2) ein Loch (23) aufweist, das sich in der Stapelrichtung (S) von einer Unterseite (12) des Grundkörpers (2) zu einer Oberseite (10) des Grundkörpers (2) erstreckt.

9. Bauelement (1) gemäß einem der vorherigen Ansprüche, wobei der Grundkörper (2) eine senkrecht zur Stapelrichtung (S) angeordnete Grundfläche (8) aufweist, die rund ist.

10. Bauelement (1) gemäß einem der Ansprüche 1 bis 8,
wobei der Grundkörper (2) eine senkrecht zur Stapelrichtung (S) angeordnete Grundfläche (8) aufweist, deren Seitenlängen zwischen 10 und 30 mm liegen.

11. Bauelement (1) gemäß einem der vorherigen Ansprüche, wobei der Grundkörper (2) in der Stapelrichtung (S) eine Höhe zwischen 0,5 und 2,0 mm aufweist.

12. Bauelement (1) gemäß einem der vorherigen Ansprüche, wobei die Innenelektroden (3, 4, 20) Kupfer aufweisen.

13. Anordnung aufweisend mehrere übereinander gestapelte Bauelemente (1) gemäß einem der vorherigen Ansprüche.

## Claims

1. Component (1) for generating active haptic feedback, comprising
a main body (2) having first and second internal electrodes (3, 4) stacked one above another in a stacking direction (S), wherein a respective piezoelectric layer (9) is arranged between the internal electrodes (3, 4),
wherein the component (1) is configured to identify a force exerted on the component (1),
wherein the component (1) is configured to generate active haptic feedback if a force exerted on the component (1) is identified, and
wherein the haptic feedback is generated by virtue of an electrical voltage being applied between the first and second internal electrodes (3, 4), said electrical voltage resulting in a change in length of the main body (2),
wherein a frustoconical metal sheet (11, 13) is arranged on a top side (10) and/or an underside (12) of the component (1),
wherein the component (1) comprises a measuring unit for measuring a voltage which is generated between the first and second internal electrodes (3, 4) and which arises on account of the force exerted on the component (1), and wherein the measuring unit is configured to identify the magnitude of the force exerted on the component (1), for which purpose, in the measuring unit, a plurality of threshold values for the voltage generated between the first and second internal electrodes (3, 4) are defined, and wherein the measuring unit is configured to check in each case which of said threshold values are exceeded.

2. Component (1) according to Claim 1,
wherein the frustoconical metal sheet (11, 13) comprises an edge region secured on the top side (10) and/or respectively the underside (12) of the component (1), and wherein the frustoconical metal sheet (11, 13) comprises a central region (15) projecting from the top side (10) and/or respectively the underside (12) in the stacking direction (S).

3. Component (1) according to either of the preceding claims,
wherein the metal sheet (11, 13) comprises titanium.

4. Component (1) according to any of the preceding claims,
furthermore comprising a third internal electrode (20), which is connected to a measurement contact.

5. Component (1) according to Claim 4,
wherein the component (1) is configured to measure a voltage which is generated between the third internal electrode (20) and one of the first internal electrodes (3) and which arises on account of a force exerted on the component (1), and
wherein the component (1) is configured to identify the force exerted on the component (1) on the basis of the measured voltage.

6. Component (1) according to either of Claims 4 and 5,
wherein the third internal electrode (20) is arranged centrally in the stacking direction (S) in a stack of first and second internal electrodes (3, 4).

7. Component (1) according to either of Claims 4 and 5,
wherein the third internal electrode (20) is arranged in the main body (2) in such a way that all first and second internal electrodes (3, 4) are arranged on one side of the third internal electrode (20).

8. Component (1) according to any of the preceding claims,
wherein the main body (2) comprises a hole (23) extending in the stacking direction (S) from an underside (12) of the main body (2) to a top side (10) of the main body (2).

9. Component (1) according to any of the preceding claims,
wherein the main body (2) comprises a base surface (8) arranged perpendicularly to the stacking direction (S), said base surface being round.

10. Component (1) according to any of Claims 1 to 8, wherein the main body (2) comprises a base surface (8) arranged perpendicularly to the stacking direction (S), the side lengths of said base surface being between 10 and 30 mm.

11. Component (1) according to any of the preceding claims,
wherein the main body (2) has a height of between 0.5 and 2.0 mm in the stacking direction (S).

12. Component (1) according to any of the preceding claims,
wherein the internal electrodes (3, 4, 20) comprise copper.

13. Arrangement comprising a plurality of components (1) according to any of the preceding claims which are stacked one above another.

## Revendications

1. Composant (1) destiné à générer une rétroaction haptique active,
possédant
un corps de base (2) avec des première et deuxième électrodes intérieures (3, 4) empilées l'une sur l'autre dans une direction d'empilement (S), une couche piézoélectrique (9) étant respectivement disposée entre les électrodes intérieures (3, 4),
le composant (1) étant configuré pour reconnaître une force exercée sur le composant (1),
le composant (1) étant configuré pour générer une rétroaction haptique active lorsqu'une force exercée sur le composant (1) est reconnue, et
la rétroaction haptique étant générée en appliquant entre les première et deuxième électrodes internes (3, 4) une tension électrique qui entraîne une modification de la longueur du corps de base (2),
une tôle tronconique (11, 13) étant disposée sur un côté supérieur (10) et/ou un côté inférieur (12) du composant (1),
le composant (1) possédant une unité de mesure destinée à mesurer une tension générée entre les première et deuxième électrodes internes (3, 4), qui se produit en conséquence de la force exercée sur le composant (1), et l'unité de mesure étant configurée pour reconnaître l'importance de la force exercée sur le composant (1), plusieurs valeurs de seuil étant définies à cet effet dans l'unité de mesure pour la tension générée entre les première et deuxième électrodes intérieures (3, 4), et l'unité de mesure étant configurée pour vérifier respectivement lesquelles de ces valeurs de seuil sont dépassées.

2. Composant (1) selon la revendication 1,
la tôle tronconique (11, 13) possédant une zone de bord qui est fixée sur le côté supérieur (10) ou le côté inférieur (12) du composant (1), et la tôle tronconique (11, 13) possédant une zone centrale (15) qui fait saillie dans la direction d'empilement (S) depuis le côté supérieur (10) ou le côté inférieur (12).

3. Composant (1) selon l'une des revendications précédentes,
la tôle (11, 13) présentant du titane.

4. Composant (1) selon l'une des revendications précédentes,
possédant en outre une troisième électrode interne (20) qui est connectée à un contact de mesure.

5. Composant (1) selon la revendication 4,
le composant (1) étant configuré pour mesurer une tension générée entre la troisième électrode interne (20) et l'une des premières électrodes internes (3), laquelle se produit en conséquence d'une force exercée sur le composant (1), et
le composant (1) étant configuré pour reconnaître, à l'aide de la tension mesurée, la force exercée sur le composant (1).

6. Composant (1) selon l'une des revendications 4 ou 5,
la troisième électrode interne (20) étant disposée au centre d'un empilement de premières et de deuxièmes électrodes internes (3, 4) dans la direction d'empilement (S).

7. Composant (1) selon l'une des revendications 4 ou 5,
la troisième électrode interne (20) étant disposée dans le corps de base (2) de telle sorte que toutes les première et deuxième électrodes internes (3, 4) sont disposées sur un côté de la troisième électrode interne (20).

8. Composant (1) selon l'une des revendications précédentes,
le corps de base (2) possédant un trou (23) qui s'étend dans la direction d'empilement (S) depuis un côté inférieur (12) du corps de base (2) jusqu'à un côté supérieur (10) du corps de base (2).

9. Composant (1) selon l'une des revendications précédentes,
le corps de base (2) possédant une surface de base (8) disposée perpendiculairement à la direction d'empilement (S), qui est ronde.

10. Composant (1) selon l'une des revendications 1 à 8, le corps de base (2) possédant une surface de base (8) disposée perpendiculairement à la direction d'empilement (S), dont les longueurs des côtés sont comprises entre 10 et 30 mm.

11. Composant (1) selon l'une des revendications précédentes,
le corps de base (2) ayant une hauteur comprise entre 0,5 et 2,0 mm dans la direction d'empilement (S).

12. Composant (1) selon l'une des revendications précédentes,
les électrodes internes (3, 4, 20) présentant du cuivre.

13. Arrangement possédant plusieurs composants (1) empilés les uns sur les autres selon l'une des revendications précédentes.
